# EUROPÄISCHE PATENTSCHRIFT

(11) **EP 2 820 168 B1**
(45) Veröffentlichungstag und Bekanntmachung des Hinweises auf die Patenterteilung: **17.06.2020**
(21) Anmeldenummer: 13716153.5
(22) Anmeldetag: 25.02.2013
(51) Int. Cl.: B22D 11/12, C23C 16/30, C23C 16/44, C23C 30/00, C23C 16/56, C23C 28/04, C01B 35/08, B22D 11/128

(54) **VERFAHREN ZUR HERSTELLUNG EINER HARTSTOFFSCHICHT AUF EINEM SUBSTRAT, HARTSTOFFSCHICHT SOWIE ZERSPANWERKZEUG**
METHOD FOR PRODUCING A HARD MATERIAL LAYER ON A SUBSTRATE, HARD MATERIAL LAYER AND CUTTING TOOL
PROCÉDÉ DE PRODUCTION D'UNE COUCHE DE MATÉRIAU DUR SUR UN SUBSTRAT, COUCHE DE MATÉRIAU DUR ET OUTIL D'USINAGE PAR ENLÈVEMENT DE COPEAUX

(30) Priorität: 27.02.2012 AT 742012 U
(43) Veröffentlichungstag der Anmeldung: 07.01.2015
(73) Patentinhaber: Ceratizit Austria Gesellschaft m.b.H., 6600 Reutte (AT)
(72) Erfinder: CZETTL, Christoph, A-8761 Pöls (AT)
(74) Vertreter: Ciesla, Dirk
(86) Internationale Anmeldenummer: PCT/AT2013/000034
(87) Internationale Veröffentlichungsnummer: WO 2013/126935

(56) Entgegenhaltungen:
- EP-A1- 1 473 101
- EP-A2- 0 306 077
- WO-A1-00/52224
- WO-A1-2012/133461
- DE-A1- 4 343 354
- US-A1- 2004 259 353
- HOLZSCHUH H: "Chemical-vapor deposition of wear resistant hard coatings in the Ti-B-C-N system: properties and metal-cutting tests", INTERNATIONAL JOURNAL OF REFRACTORY METALS AND HARD MATERIALS, ELSEVIER PUBLISHERS, BARKING, GB, Bd. 20, Nr. 2, 1. März 2002 (2002-03-01), Seiten 143-149, XP004382026, ISSN: 0263-4368, DOI: 10.1016/S0263-4368(02)00013-6
- HOLZSCHUH H: "Moderate temperature CVD of Ti-B-C-N on cemented carbide tools: properties and metal-cutting tests", JOURNAL DE PHYSIQUE IV, EDITIONS DE PHYSIQUE. LES ULIS CEDEX, FR, Bd. 10, Nr. 2, 10. September 1999 (1999-09-10), Seiten pr2-49, XP008094538, ISSN: 1155-4339

## Beschreibung

### Technisches Gebiet

Die vorliegende Erfindung betrifft ein Verfahren zur Herstellung einer Hartstoffschicht auf einem Substrat, wobei eine TiCNB Hartstoffschicht auf dem Substrat abgeschieden wird nach Anspruch 1. Das Verfahren dient bevorzugt zur Herstellung von Zerspanwerkzeugen zum Drehen, Fräsen oder anderen spanenden Bearbeitungsverfahren.

Weiterhin betrifft die vorliegende Erfindung eine Hartstoffschicht nach Anspruch 7 sowie ein Zerspanwerkzeug nach Anspruch 8, bevorzugt einen Schneidkörper oder eine Wendeschneidplatte.

### Stand der Technik

Es ist bekannt, zur Erhöhung der Verschleißbeständigkeit auf verschleißbeanspruchten Zerspanwerkzeugen und anderen Bauteilen TiCNB Hartstoffbeschichtungen aufzubringen. Entsprechende Zerspanwerkzeuge werden beispielsweise in Form von Schneidkörpern oder Wendeschneidplatten in Dreh- und Fräsvorrichtungen verwendet.

Die jeweilige Hartstoffbeschichtung wird dabei üblicherweise mittels physikalischer oder chemischer Schichtabscheidung aus der Dampfphase beziehungsweise der Gasphase auf ebenfalls verschleißbeständige Substratwerkstoffe abgeschieden. Als Substratwerkstoffe werden hier beispielsweise Hartmetalle, Cermets, Hartstoffe oder Werkzeugstähle verwendet.

Unter Hartmetall wird ein Verbundwerkstoff verstanden, welcher üblicherweise eine Hauptphase aus Wolframcarbid (WC) sowie gegebenenfalls Phasen von weiteren Carbiden und einen metallischen Binder beziehungsweise eine entsprechende metallische Matrix umfasst. Als metallische Matrix werden üblicherweise Cobalt, Nickel und/oder Eisen eingesetzt. Als weitere Carbide können Carbide von Metallen der vierten (Titangruppe), fünften (Vanadiumgruppe) und sechsten (Chromgruppe) Nebengruppe, also beispielsweise von Tantal, Niob, Hafnium, Zirkon, etc., verwendet werden.

Unter Cermets werden Verbundwerkstoffe verstanden, die bezüglich der Carbide Titancarbid als Hauptphase enthalten. Typischerweise wird der Hauptanteil des Binders durch Nickel und/oder Cobalt gebildet.

Unter Hartstoffen versteht man Werkstoffe mit einer Härte von mehr als 10 GPa.

Werkzeugstähle wiederum sind nach DIN 17300 Stähle, welche durch ihre Anwendung in Werkzeugen definiert werden.

Bei den Beschichtungsverfahren kann die Beschichtung der entsprechenden Substrate zur Herstellung der Zerspanwerkzeuge auf chemischem oder auf physikalischem Wege erfolgen. Entsprechende Beschichtungsverfahren sind das CVD-Verfahren, welches auch als chemische Gasphasenabscheidung (englisch: chemical vapour deposition) bekannt ist, sowie das PVD-Verfahren, welches auch als physikalische Gasphasenabscheidung (englisch: physical vapour deposition), bekannt ist.

Beim CVD-Verfahren, weiches im Nachfolgenden hauptsächlich betrachtet werden wird, werden im Wesentlichen drei unterschiedliche Arten der Prozessführung unterschieden. Das HT-CVD Verfahren, welches auch als Hochtemperatur-CVD Verfahren bekannt ist, wird bei Temperaturen von ca. 900 °C bis 1100 °C durchgeführt. Das MT-CVD Verfahren, welches auch als Mitteltemperatur-CVD Verfahren bekannt ist, wird bei Temperaturen von ca. 700 °C bis 900 °C durchgeführt. Weiterhin ist ein PA-CVD Verfahren, oder auch Plasmaaktiviertes-CVD Verfahren, bekannt, welches bei Temperaturen von 450 °C bis 650 °C durchgeführt wird, welches aber im Nachfolgenden nicht weiter betrachtet wird.

Bei dem CVD-Verfahren werden unter Grobvakuumbedingungen (10³ bis 10⁵ Pa) und unter Zufuhr von Wärme- oder Strahlungsenergie chemische Reaktionen ausgelöst, weiche neben den flüchtigen Produkten die dann technisch nutzbare Hartstoffschicht auf dem entsprechenden Substrat ergeben.

Bezüglich der TiCNB Hartstoffbeschichtungen ist es bekannt, diese aus einem Gassystem bestehend aus TiCl₄, CH₄, N₂, H₂ und BCl₃ in einem HT-CVD Verfahren auf einem Substrat abzuscheiden, wobei hier Temperaturen von 950 °C bis 1050 °C verwendet werden. Dieses Verfahren ist beispielsweise in H. Holzschuh, in: G. Kneringer, P. Rödhammer, H. Wildner (Herausgeber), Plansee Seminar, Plansee Holding AG, Reutte, 2001, Vol. 2, Seiten 441ff*.,* beschrieben.

Aus der genannten Veröffentlichung ist auch ein MT-CVD Verfahren bekannt, mittels welchem eine TiCNB Hartstoffschicht bei Temperaturen von 700 °C bis 900 °C auf einem Substrat abgeschieden wird. Das Gassystem ist gegenüber dem HT-CVD Verfahren dahingehend verändert, dass anstelle des im HT-CVD Verfahren verwendeten Methans (CH₄) nun Acetonitril (CH₃CN), also ein Nitril, als organischer Precursor verwendet wird. Durch die Verwendung des gegenüber dem Methan deutlich reaktiveren Acetonitrils kann auf diese Weise eine Abscheidung der TiCNB Hartstoffschicht auch bei den im MT-CVD Verfahren verwendeten niedrigeren Temperaturen erreicht werden.

Bei dem genannten MT-CVD Verfahren zum Abscheiden einer TiCNB Hartstoffbeschichtung auf einem Substrat unter Verwendung von Acetonitril ist jedoch das Atomverhältnis von Kohlenstoff C zu Stickstoff N in dem TiCₓN_{y}B_{1-x-y} System auf 0,50 ≤X≥ 0,67 beschränkt. Durch die Verwendung des Acetonitrils als organischen Precursor ist zwar aufgrund dessen höherer Reaktivität eine Abscheidung des TiCNB bei den im MT-CVD niedrigeren Temperaturen von 700 °C bis 900 °C möglich, das Atomverhältnis von Kohlenstoff zum Stickstoff kann jedoch in dem TiCₓN₁₋ₓ System nicht über X=0,67 hinaus erhöht werden *(siehe auch* A. Larsson, S. Ruppi, Thin Solid Films 402/1-2 (2002), Seiten 203ff*.).* Diese Begrenzung der möglichen Zusammensetzungen der TiCNB Hartstoffschicht im MT-CVD Verfahren ergibt sich aus dem durch das Acetonitril beschränkten Angebotsverhältnis aus Kohlenstoff zu Stickstoff.

Im MT-CVD Verfahren kann aufgrund der gegenüber dem HT-CVD Verfahren niedrigeren Temperaturen eine Entkohlung der Grenzfläche des Substrats während der Abscheidung im CVD-Reaktor reduziert werden und entsprechend kann die Ausbildung einer spröden Eta-Phase (η-Phase) im Bereich der Grenzfläche des Substrats auf diese Weise verringert oder vermieden werden. Durch die Verringerung oder Vermeidung der Ausbildung der Eta-Phase können die Haftungseigenschaften der TiCNB Hartstoffschicht auf dem Substrat verbessert werden und damit können die Eigenschaften des auf diese Weise hergestellten Zerspanwerkzeugs verbessert werden.

Weiterhin ist es bekannt, dass das Dotieren eines TiCN-Systems mit Bor die Härte der abgeschiedenen Hartstoffschicht weiter erhöhen kann (siehe auch H. Holzschuh, in: G. Kneringer, P. Rödhammer, H. Wildner (Herausgeber), Plansee Seminar, Plansee Holding AG, Reutte, 2001, Vo/. 2, Seiten 441ff*.*)*.* Bekannt ist es aber auch, dass bei Beschichtungstemperaturen oberhalb von 900 °C durch Bordiffusion eine spröde Cobalt-Wolfram-Bor Phase an der entsprechenden Grenzfläche auftritt, welche sich negativ auf die Zerspanungseigenschaften der auf diese Weise hergestellten Hartstoffschicht auswirken kann (siehe auch H. Holzschuh, in: G. Kneringer, P. Rödhammer, H. Wildner (Herausgeber), Plansee Seminar, Plansee Holding AG, Reutte, 2005, Seiten 801ff*.*)*.*

DE 43 43 354 A1 offenbart ein Verfahren zur Herstellung einer Hartstoffschicht.

WO 2012/13346 A1 offenbart ein mit einem harten Film überzogenes Element.

In Holzschuh, H. "Moderate temperature CVD of Ti-BCN on cemented carbide tools: Properties and metal-cutting tests." Le Journal de Physique IV 10.PR2 (2000): Pr2-49 sind weitere Hartstoffschichten offenbart. Ähnliche Hartstoffschichten sind bekannt aus HOLZSCHUH H: "Chemical-vapor deposition of wear resistant hard coatings in the Ti-B-C-N system: properties and metal-cutting tests",INTERNATIONAL JOURNAL OF REFRACTORY METALS AND HARD MATERIALS, ELSEVIER PUBLISHERS, BARKING, GB, Bd. 20, Nr. 2, 1. März 2002 (2002-03-01), Seiten 143-149.

### Darstellung der Erfindung

Ausgehend von dem bekannten Stand der Technik ist es eine Aufgabe der vorliegenden Erfindung, ein Verfahren zur Herstellung einer Hartstoffschicht auf einem Substrat, sowie eine Hartstoffschicht und ein Zerspanwerkzeug mit weiter verbesserten Eigenschaften bezüglich der Verschleißfestigkeit anzugeben.

Diese Aufgabe wird durch ein Verfahren mit den Merkmalen des Anspruchs 1 gelöst. Vorteilhafte Weiterbildungen ergeben sich aus den abhängigen Unteransprüchen.

In einem Verfahren zur Herstellung einer Hartstoffschicht auf einem Substrat wird eine TiCNB Hartstoffschicht durch chemische Gasphasenabscheidung (CVD) aus einem Gassystem umfassend einen Titanträger, einen Borträger, einen Stickstoffträger, vorzugsweise mindestens einen Stickstoffträger, und einen Kohlenstoffträger, vorzugsweise mindestens einen Kohlenstoffträger, abgeschieden. Der offenbarte Kohlenstoffträger umfasst ein Alkan mit mindestens zwei C-Atomen, ein Alken oder ein Alkin.

Bevorzugt ist der Kohlenstoffträger ein Alkan mit mindestens zwei C-Atomen, ein Alken oder ein Alkin.

Unter einem Alkan mit mindestens zwei C-Atomen werden die Alkane ab Ethan (C₂H₆) verstanden, entsprechend mit einer allgemeinen Summenformel CₙH₂ₙ₊₂ mit n=2, 3, 4, ... .

Alkene werden durch die allgemeine Summenformel CnH₂ₙ mit n=2, 3, 4, ... beschrieben.

Alkine werden durch die allgemeine Summenformel CₙH₂ₙ-₂ mit n=2, 3, 4, ... beschrieben.

Durch die Verwendung eines Alkans mit mindestens zwei C-Atomen, eines Alkens oder eines Alkins kann mit einem CVD Verfahren eine TiCNB Hartstoffschicht auf dem Substrat abgeschieden werden, wobei das Kohlenstoff-zu-Stickstoff Verhältnis frei eingestellt werden kann. Gegenüber dem üblicherweise verwendeten Methan weisen die genannten Alkane, Alkene und Alkine eine höhere Reaktivität auf, so dass die Abscheidung der TiCNB Schicht bereits bei niedrigeren Temperaturen und besonders auch im MT-CVD Verfahren stattfinden kann.

Weiterhin ergibt sich auch bei niedrigeren Reaktionstemperaturen nicht die Beschränkung des Kohlenstoff-zu-Stickstoff Verhältnisses, welches durch die herkömmliche Verwendung von Acetonitril vorgegeben war, sondern das Kohlenstoff-zu-Stickstoff Verhältnis im auf dem Substrat abgeschiedenen TiCₓN_{y}B_{1-x-y} System kann prinzipiell zwischen 0 ≤X≤ 1 eingestellt werden. Bevorzugt ist es 0,70 ≤ X ≤ 1,0, erfindungsgemäß 0,75 ≤ X ≤ 0,85, bei einer Reaktionstemperatur von 750 °C bis 930 °C. Die genaue Zusammensetzung der auf dem Substrat abgeschiedenen Hartstoffschicht kann beispielsweise mittels des GDOES Verfahrens ermittelt werden.

Dadurch, dass eine TiCNB Hartstoffschicht auf dem Substrat abgeschieden werden kann, bei welcher der Kohlenstoff zu Stickstoff Anteil innerhalb eines deutlich größeren Bereichs eingestellt werden kann als in den herkömmlichen MT-CVD Verfahren, und gleichzeitig die Vorteile des MT-CVD Verfahrens beibehalten werden können, nämlich dass durch die niedrigere Temperatur im Reaktor eine Verringerung oder Vermeidung einer Unterkohlung des Substrats stattfindet, kann eine besonders leistungsfähige Hartstoffschicht ausgebildet werden. Durch die mögliche Verringerung der Reaktionstemperaturen wird weiterhin die Ausbildung einer spröden Eta-Phase an der Grenzfläche zwischen dem Substrat und der Beschichtung reduziert beziehungsweise im Wesentlichen vermieden. Auch auf diese Weise können die Zerspanungseigenschaften einer auf diese Weise hergestellten Hartstoffschicht auf dem Substrat verbessert werden. Insbesondere werden auch die Haftungseigenschaften der Hartstoffschicht auf dem Substrat auf diese Weise verbessert, da die Haftung zwischen der Hartstoffschicht und dem Substrat auf einer Grenzschicht stattfindet, welche im Wesentlichen frei von einer Eta-Phase ist.

Erfindungsgemäß wird Ethan (C₂H₆) als Kohlenstoffträger verwendet. Ethan bietet neben seiner hohen Reaktivität auch eine einfache Handhabung im MT-CVD Verfahren. Aufgrund dem gegenüber dem herkömmlichen MT-CVD Verfahren verwendeten Acetonitril ist Ethan ungleich reaktiver. Entsprechend führen bereits geringe Dosierungsänderungen des Ethans zu großen Änderungen in der Reaktion zur Abscheidung der TiCNB Hartstoffschicht auf dem Substrat. Bevorzugt ist der Kohlenstoffträger bei Raumtemperatur flüssig oder gasförmig, um die Verarbeitung im MT-CVD-Verfahren zu vereinfachen. Unter Raumtemperatur wird hier eine Temperatur von 293K (20 °C) verstanden.

Erfindungsgemäß wird als Titanträger TiCl₄, als Borträger BCl₃ und als Stickstoffträger N₂ verwendet. Das Gassystem weist erfindungsgemäß H₂ als Ausgleichsgas sowie besonders bevorzugt mindestens ein weiteres Ausgleichsgas wie beispielsweise Argon aufweisen.

Das Verfahren wird erfindungsgemöß bei einer Temperatur von 750°C bis 930 °C, bevorzugt von 800°C bis 900 °C, durchgeführt, um eine Ausbildung einer spröden Eta-Phase an der Grenzfläche des Substrats zu reduzieren beziehungsweise ganz zu verhindern. Aufgrund der höheren Reaktivität des verwendeten Kohlenstoffträgers findet dennoch eine zuverlässige Abscheidung der TiCNB Hartstoffschicht auf dem Substrat statt, insbesondere bei einem voreingestellten Kohlenstoff-zu-Stickstoff Verhältnis.

Mit Vorteil wird das Verfahren bei einem Druck von 50 mbar bis 1000 mbar, bevorzugt von 80 mbar bis 500 mbar, durchgeführt. Hierbei handelt es sich um bevorzugte Drücke, um in einem CVD Prozess die gewünschten Hartstoffschichten abzuscheiden.

Bevorzugt wird vor dem Aufbringen der TiCNB Hartstoffschicht auf das Substrat eine Diffusionsbarriere, bevorzugt Titannitrid (TiN), aufgebracht. Die Dicke der Diffusionsbarriere ist dabei bevorzugt 0,4 µm bis 1 µm. Auf diese Weise kann eine Diffusion von Bor in das Substrat verringert beziehungsweise verhindert werden und entsprechend eine spröde Wolfram-Cobalt-Bor Phase an der Grenzfläche vermieden beziehungsweise verringert werden. Dadurch kann das Haftvermögen der TiCNB Hartstoffschicht auf dem Substrat verbessert werden und die Zerspanungseigenschaften eines auf diese Weise hergestellten Zerspanwerkzeugs verbessert werden.

Auf der TiCNB Haftstoffschicht können weiterhin bevorzugt eine oder mehrere Deckschichten und/oder Funktionsschichten angebracht werden, beispielsweise eine Aluminiumoxid (Al₂O₃)-SChicht, besonders bevorzugt eine Korundschicht (α-Al₂O₃) oder eine Zr(C,N)-Schicht. Auf diese Weise kann die Härte der Oberflächen noch besser an die jeweilig beabsichtigten Anwendungen angepasst werden. Weiterhin können als Funktions- und/oder Deckschichten oberhalb der TiCNB-Schicht auch Schicht(en) aus Nitriden, Carbiden, Carbonitriden, Carboxynitriden und/oder Bornitriden basierend auf Ti ausgebildet sein, die zusätzlich auch noch Anteile von Al, Zr, Hf, Ta und/oder Nb enthalten können.

Je nach Anwendungsbereich des jeweiligen Zerspanwerkzeugs werden bevorzugt unterschiedliche Schichtdicken der TiCNB Schicht abgeschieden, wobei die TiCNB Schicht bevorzugt in einem Bereich von 1 µm bis 15 µm, bevorzugt in einem Bereich von 2 µm bis 12 µm, auf dem Substrat abgeschieden wird. Für Zerspanwerkzeuge für Fräsanwendungen wird bevorzugt eine TiCNB Schicht der Dicke in einem Bereich von 3 µm bis 4 µm abgeschieden, für Zerspanwerkzeuge zum Drehen von Werkstücken wird bevorzugt eine TiCNB Hartstoffschicht der Dicke 10 µm abgeschieden.

In einer weiteren vorteilhaften Ausgestaltung des Verfahrens wird als Substrat ein Hartmetall, ein Cermet, ein Hartstoff oder ein Werkzeugstahl verwendet, wobei das Substrat vor dem Aufbringen der jeweiligen Beschichtung bevorzugt vorbehandelt, besonders bevorzugt poliert, wird.

Die TiCNB Schicht beziehungsweise die aufgebrachte Hartstoffschicht, bevorzugt in Verbindung mit der jeweiligen Deckschicht, wird bevorzugt nachbehandelt, beispielsweise durch Nassstrahlen, Trockenstrahlen oder Färben, wobei hier bevorzugt die Oberflächenstruktur und/oder die Oberflächenrauhigkeit an den jeweiligen vorgesehenen Anwendungsbereich angepasst wird.

Die Härte der TiCNB Schicht kann durch das Einstellen des Borgehaltes in dem Gassystem weiter erhöht werden. Die TiCNB Hartstoffschicht auf dem Substrat weist dann einen Borgehalt von bis zu 5 At.-%, bevorzugt bis zu 1 At.-%, mindestens aber 0,01 At.-% auf, gemessen mit dem GDOES Verfahren. Bezogen auf die Summenformel TiCₓN_{y}B_{1-x-y} bedeutet dies: 0,01 At.-% ≤ 1-x-y ≤ 5 At.-%, bevorzugt 0,01 At.-% ≤ 1-x-y ≤ 1 At.-%.

Die oben genannte Aufgabe wird weiterhin durch eine Hartstoffschicht auf einem Substrat gelöst, wobei die Hartstoffschicht nach dem vorbeschriebenen Verfahren hergestellt ist.

Die oben genannte Aufgabe wird weiterhin auch durch ein Zerspanwerkzeug, bevorzugt einen Schneidkörper oder eine Wendeschneidplatte, umfassend ein Substrat gelöst, wobei eine Hartstoffschicht nach dem vorbeschriebenen Verfahren auf dem Substrat aufgebracht ist.

Die Aufgabe wird weiterhin durch ein Zerspanwerkzeug mit den Merkmalen des Anspruchs 8 gelöst. Vorteilhafte Weiterbildungen ergeben sich aus den von diesem Anspruch abhängigen Unteransprüchen.

Entsprechend weist das Zerspanwerkzeug ein Substrat aus Hartmetall auf, auf welchem eine TiCNB Hartstoffschicht aufgebracht ist, wobei das Verhältnis der Kohlenstoffatome zu den Stickstoffatomen in dem auf dem Substrat abgeschiedenen erfindungsgemäß 0,75 ≤ X ≤ 0,85, ist. Offenbart ist auch ein TiCxN_{y}B_{1-x-y} System 0,70 ≤ X ≤ 1,0. Erfindungsgemäß ist das Schliffbild nach einer Murakami-Ätzung im Wesentlichen frei von einer Eta-Phase.

Der Schliff wird dabei in einer Ebene, welche im Wesentlichen senkrecht zur Ebene der Grenzfläche zwischen Substrat und Beschichtung liegt, angelegt. Der Schliff wird anschließend poliert und dann einer Murakami-Ätzung unterzogen, wobei der Schliff bei Raumtemperatur bei einer kurzen Einwirkzeit von 1-2s mit der Standard Murakami Ätzflüssigkeit bestehend aus 10 g KOH, 10 g K₃Fe(CN)₆, und 10 mml H₂O behandelt wird. Die nachfolgende Betrachtung des so vorbereiteten Schliffbildes erfolgt mittels eines Lichtmikroskops bei 1.000 facher Vergrößerung.

Im Schliffbild wird die Eta-Phase durch die entsprechende Murakami-Ätzung sichtbar gemacht. Durch das oben beschriebene Beschichtungsverfahren wird, wie bereits diskutiert, eine Abscheidung von TiCNB mit einem TiCₓN_{y}B_{1-x-y} System bei 0,70 ≤ X ≤ 1,0, bevorzugt bei 0,75 ≤ X ≤ 0,85 bereits bei geringeren Temperaturen möglich. Entsprechend kommt es im Wesentlichen zu keiner Ausbildung einer Eta-Phase an der Grenzfläche des Substrats durch eine temperaturgetriebene Unterkohlungsreaktion, wodurch eine Verbesserung der Eigenschaften der Hartstoffbeschichtung erreicht werden kann.

Bevorzugt ist im Schliffbild in einem Tiefenbereich im Substrat von 0,4 µm bis 1 µm ab der Grenzfläche zwischen dem Substrat und der Beschichtung keine Eta-Phase nachweisbar. Besonders bevorzugt ist überhaupt keine Eta-Phase im entsprechend behandelten Schliffbild nachweisbar.

Mit Vorteil weist das Zerspanwerkzeug eine TiCNB Schicht mit einer Dicke von 1 µm bis 15 µm, bevorzugt eine Dicke von 2 µm bis 12 µm auf, und besonders bevorzugt für Fräsanwendungen eine Dicke von 3 µm bis 4 µm, und besonders bevorzugt für Drehanwendungen eine Dicke von 10 µm.

Vorteilhaft ist das Substrat des Zerspanwerkzeugs vor dem Aufbringen der jeweiligen Beschichtung vorbehandelt, bevorzugt poliert.

Um eine besonders vorteilhafte Anwendbarkeit des Zerspanwerkzeugs zu erreichen, ist die TiCNB Hartstoffschicht bevorzugt nachbehandelt und die Oberflächenstruktur und/oder die Oberflächenrauhigkeit an die jeweilige Anwendung angepasst, besonders bevorzugt durch Nassstrahlen, Trockenstrahlen und/oder Färben.

### Kurze Beschreibung der Figuren

Die Figuren zeigen:
- Figur 1: die Oberflächenstrukturen und Schnittstrukturen der TiCNB Hartstoffschicht bei unterschiedlichen Borgehalten,
- Figur 2: Diagramme bezüglich Dreh- und Frästests, welche an den mit unterschiedlichen Borgehalten hergestellten TiCNB Hartstoffschichten durchgeführt wurden, und
- Figur 3: Schliffbilder von mit unterschiedlichen Borgehalten hergestellten TiCNB Hartstoffschichten auf einem Substrat.

### Detaillierte Beschreibung bevorzugter Ausführungsbeispiele

Im Folgenden werden bevorzugte Ausführungsbeispiele anhand der Figuren beschrieben. Dabei werden gleiche, ähnliche oder gleichwirkende Elemente mit identischen Bezugszeichen bezeichnet und auf eine wiederholte Beschreibung dieser Elemente wird teilweise verzichtet, um Redundanzen in der Beschreibung zu vermeiden.

Nachfolgend wird das Verfahren zur Herstellung von TiCNB Hartstoffschichten auf einem Substrat noch einmal exemplarisch anhand eines Beispieles erläutert.

Grundsätzlich wird die TiCNB Hartstoffschicht auf dem Substrat durch chemische Gasphasenabscheidung, also CVD, aus einem Gasgemisch umfassend einen Titanträger, bevorzugt TiCl₄, einen Borträger, bevorzugt BCl₃, einen Stickstoffträger, bevorzugt N₂, und einen Kohlenstoffträger, hergestellt. Als Kohlenstoffträger wird ein Alkan mit mindestens zwei C-Atomen, also ab C₂H₆ (Ethan), ein Alken, bevorzugt Ethen (C₂H₄), oder ein Alkin, bevorzugt Ethin (C₂H₂), verwendet.

Eine Abscheidung einer TiCNB Schicht mit einem freieinstellbaren Atomverhältnis der Kohlenstoffatome zu den Stickstoffatomen in dem TiCₓN_{y}B_{1-x-y} System von 0 ≤ X ≤ 1, bevorzugt 0,10 ≤ X ≤ 0,90, ist auf diese Weise auch bei Temperaturen unterhalb von 930 °C möglich. Durch die Verwendung eines besonders reaktiven organischen Precursors in Form des Ethans, Ethens oder Ethins können auf diese Weise auch TiCNB Hartstoffschichten hergestellt werden, welche einen hohen Kohlenstoffgehalt aufweisen. Der höhere Kohlenstoffgehalt führt zu einer weiteren Härtesteigerung der TiCNB Hartstoffschicht, wobei eine solche Zusammensetzung durch die Verwendung von Alkanen, Alkenen oder Alkinen als dem organischen Precursor und der damit verbundenen erhöhten Reaktivität im MT-CVD Verfahren auf dem Substrat abgeschieden werden kann. Die niedrigeren Temperaturen des MT-CVD Verfahrens führen aber gleichzeitig dazu, dass die Ausbildung einer spröden Eta-Phase verringert oder ganz vermieden wird, so dass im Vergleich die Zähigkeit des Schneideinsatzes der auf diese Weise hergestellten TiCNB Hartstoffschicht gegenüber der im herkömmlichen HT-CVD Verfahren hergestellten verbessert ist. Auf diese Weise lassen sich entsprechend Schneidkörper für Zerspanwerkzeuge mit verbesserten Eigenschaften herstellen.

Nachfolgend wird ein konkretes Ausführungsbeispiel angegeben:

### Beispiel

Vier unterschiedliche Beschichtungen wurden mittels einer kommerziell erhältlichen SuCoTec SCT600 TH CVD Einheit auf Substraten aufgebracht. Die unterschiedlichen Beschichtungen unterschieden sich im Gehalt des Borträgers im zur Abscheidung der TiCNB verwendeten Gassystem.

Als Substrat wurde ein Hartmetall mit 12 Gew.-% Cobalt und 11 Gew.% Mischkarbiden verwendet, welches vor der Beschichtung poliert wurde. Auf dem Substrat wurde eine 0,4 µm starke TiN Diffusionsbarriere abgeschieden.

Dann wurde eine TiCₓN_{y}B_{1-x-y} Schicht auf der TiN Diffusionsbarriere abgeschieden. Die Abscheidung wurde mittels eines Gassystems unter Verwendung von TiCl₄, C₂H₆, H₂, N₂, BCl₃ bei 920 °C und bei einem Druck von 1,6 x 10⁴ Pa durchgeführt. Die Grundzusammensetzung des Gassystems zur Herstellung der TiCₓN_{y}B_{1-x-y} Schicht war 23,3 vol.-% N₂, 1,2 vol.-% TiCl₄, 1,5 vol.-% C₂H₆, und H₂ zum Ausgleich. Der gesamte Gasfluss war 65,4 l/min. Als organischer Precursor wurde entsprechend Ethan verwendet.

Vier unterschiedliche Beschichtungen wurden durch das Hinzufügen von steigenden BCl₃ Anteilen zu dem genannten Gassystem von Oppm, 150 ppm, 380 ppm und 1070 ppm hergestellt. Eine Abscheidungszeit von 60 Minuten für die TiN Diffusionsbarriere und von 470 Minuten für die TiCNB Lage wurde für alle erzeugten Beschichtungen konstant gehalten.

Die auf diese Weise hergestellten, beschichteten Substrate wurden wie nachfolgend beschrieben analysiert.

Die Beschichtungsdicke wurde mittels optischer Lichtmikroskopie an polierten Querschnitten von Substraten an drei Positionen innerhalb des CVD-Reaktors bestimmt. Die Massenzunahme wurde unter Verwendung von einer Präzisionswaage an 33 Proben aus der Gesamtprobenanzahl gemessen.

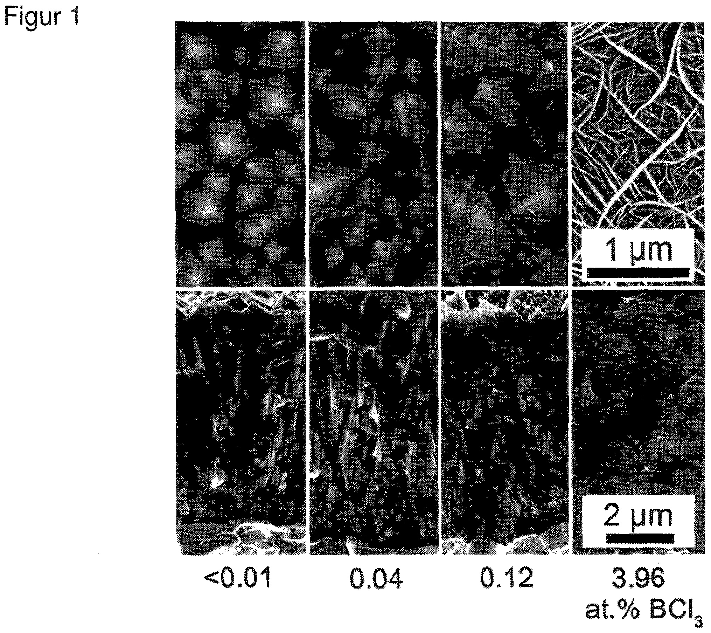

Eine Bestimmung der Oberflächentopographie und der Struktur eines Bruchquerschnitts wurde unter Verwendung eines Zeiss ULTRA 55 plus Scanning Electron Microscops (SEM) durchgeführt. Die entsprechenden Ergebnisse sind in Figur 1 zu erkennen.

In Figur 1 steigen die Borgehalte von links nach rechts an, in Übereinstimmung mit den im Gassystem verwendeten BCl₃ Anteilen von 0, 150, 380 und 1070 ppm. Diese im Gassystem verwendeten Borgehalte resultieren in den in der Figur genannten Borgehalten der TiCNB Schicht von < 0,01, 0,04, 0,12 und 3,96 At.-%.

Die entsprechenden chemischen Zusammensetzungen der TiCN basierten Beschichtungen, und insbesondere die Bestimmung des Borgehaltens in den jeweiligen Beschichtungen, wurde unter Verwendung eines Jobin-Yvon Horiba JY 10000 Glow Discharge Optical Emission Spectroscope (GDOES) gemessen.

Aus der Figur 1 ergeben sich unterschiedliche Oberflächentopographien, wobei bei bis zu 0,12 At.-% Borgehalt der Hartstoffschicht gleichförmige Körner erkannt werden können, weiche auf eine stabile Oberfläche schließen lassen. Bei 3,96 At.-% Borgehalt kippt die Oberflächentopographie hin zu einer lamellaren Struktur. Hierbei wird entsprechend bezüglich der Kristallmorphologie ein Übergang von der äquiaxialen, gleichförmigen Körnergröße zu einer lamellaren Struktur beobachtet, bei welcher die Körner vollständig aufgebrochen werden. Eine solche lamellare Struktur ist zur Beschichtung von Zerspanwerkzeugen nur eingeschränkt geeignet.

Entsprechend wird in dem hier vorgestellten Verfahren zur Herstellung einer TiCNB Hartstoffschicht der Borgehalt bevorzugt so eingestellt, dass er in der Schicht einen Anteil von bis zu 5 At.-%, bevorzugt bis zu 1 At.-%, mindestens aber 0,01 At.-% aufweist, gemessen mit GDOES.

Die auf die oben genannte Weise hergestellten Substrate, welche als Schneidkörper ausgebildet sind, wurden sowohl einem Drehtest als auch einem Frästest unterzogen. Der Drehtest war als ein Segmentdrehtest ausgebildet, welcher eine Kombination von Stirnflächen- und Längsdrehvorgang darstellt, und wurde an einem niedrig legierten Stahl nach DIN 1.7225(42CRMO4) mit einer Schneidgeschwindigkeit v_{C}=220 m/min, einer Vorschubgeschwindigkeit f = 0,4 mm unter Verwendung einer Kühlflüssigkeit durchgeführt.

Die Frästests wurden mit WC-Co Substraten mit 10 Gew.-% Cobalt in einer RPHX 1204 MO-ENM 31 Geometrie durchgeführt. Der Frästest war ein Einkantenfrästest mit einer Schnittgeschwindigkeit v_{C}=220 m/min und einer Vorschubgeschwindigkeit pro Zahn von f_{Z}=0,4mm, einer Schnitttiefe aₚ 2,5 mm, und einer Kontaktbreite von aₑ=40mm an einem martensitischen Stahl nach DIN 1.4021(X20Cr13) in einem Trockenfräsvorgang.

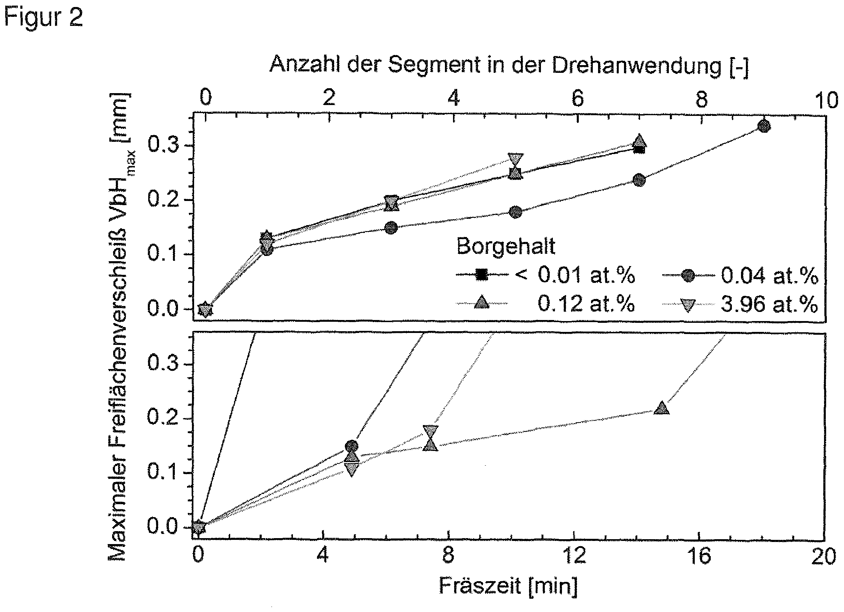

In Figur 2 sind die aus den Dreh- und Frästests erhaltenen Ergebnisse dargestellt, wobei in dem oberen Diagramm die Drehtests und in dem unteren Diagramm die Frästests dargestellt sind. Dabei ist jeweils der Freiflächenverschleiß der Hauptschneide (VbH) in Millimeter über der Standzeit (Anzahl der Segmente bei Drehtest; Fräszeit bei Frästest) aufgetragen. Bei einem Freiflächenverschleiß von 0,3 mm wird von einer Unbrauchbarkeit des Schneideinsatzes ausgegangen. Wie aus den Diagrammen ersichtlich ist, zeigen die Tests gute Ergebnisse der erfindungsgemäßen Schneideinsätze.

Eine Verbesserung der Abnutzungseigenschaften konnte bei dem kontinuierlichen Drehvorgang bei einem niedrigen Borgehalt von 0,04 At.-% der TiCNB Hartstoffbeschichtung gefunden werden. Bei einem maximalen Anteil von 3,96 At.-% wurde eine steigende Tendenz der Kraterabnutzung beziehungsweise Fiankenabnutzung beobachtet.

Auch beim Fräsen konnte eine Verbesserung bei 0,04 At.-% und bei 0,12 At.-% Borgehalt in der TiCNB Beschichtung gefunden werden. Die Leistungsfähigkeit nahm für den höchsten Anteil von 3,96 At.-% Bor deutlich ab.

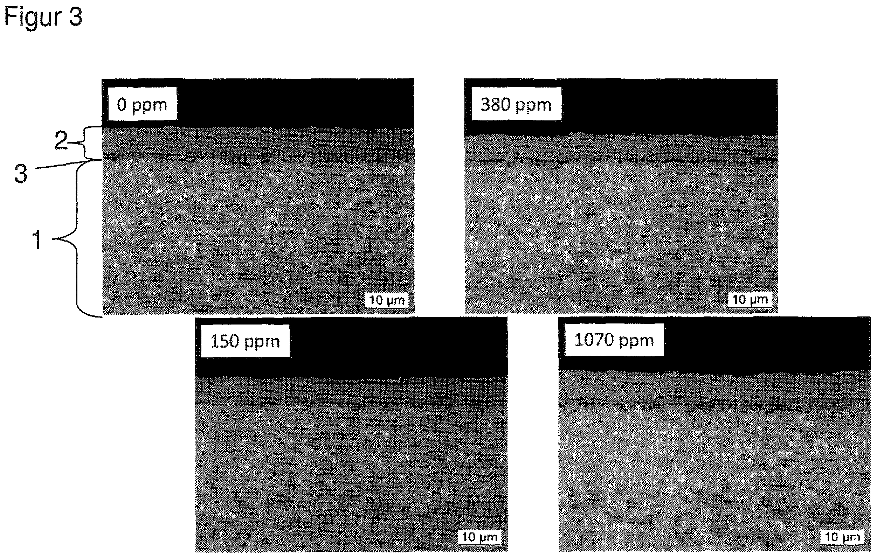

In einem weiteren Versuch wurden die in Figur 3 gezeigten Schliffbilder hergestellt. Hierzu wurden jeweils die bei 0 ppm, 150 ppm, 380 ppm und 1070 ppm hergestellten Substrate in einem Schliffbild präpariert und nach dem Murakami Verfahren angeätzt. Mittels dieses selektiven Ätzvorganges kann die Eta-Phase an der Grenzfläche 3 zwischen dem Substrat 1 und der TiCNB Schicht 2 herausgearbeitet werden.

Die Durchführung einer Murakami-Ätzung ist im Bereich der Metallurgie bekannt. Die Standard Murakami Ätzflüssigkeit ist aus 10 g KOH, 10 g K₃Fe(CN)₆, und 10 mml H₂O ausgebildet. Die mittels dieser Ätzflüssigkeit angeätzten Schliffbilder zeigen beispielsweise deutliche Abätzungen im Bereich der jeweiligen Sigma-Phase. Im durchgeführten Ätzprozess wird die spröde Eta-Phase durch die Murakami Ätzflüssigkeit abgeätzt, so dass diese in der nachfolgenden Lichtmikroskopbetrachtung deutlich sichtbar wird.

Die Murakami Ätzflüssigkeit ist auch das bekannteste Reagenz zur Herausarbeitung der Struktur in WC-Co Legierungen. Murakami's Reagenz betont dabei die Karbidkörner und verdunkelt sie leicht, wohingehend die Co-Bindermatrix unberührt bleibt. Es ist bekannt, die Murakami Ätzflüssigkeit bei WC-Co und anderen komplex gesinterten Karbiden zu verwenden und die jeweilige Probe Sekunden bis zu Minuten einzutauchen, um die Gefügestruktur sichtbar zu machen. Bei einer Verwendung von 2 bis 10 Sekunden kann die Eta-Phase farbig markiert werden. Bei längeren Ätzzeiten wird die Eta-Phase angegriffen. Die Ätzflüssigkeit wird üblicherweise bei 20 °C verwendet.

Um die Eta-Phase in dem Schliffbild sichtbar zu machen, wurde der Schliff dabei in einer Ebene, welche im Wesentlichen senkrecht zur Ebene der Grenzfläche 3 zwischen Substrat 2 und Beschichtung 1 lag, angelegt. Der Schliff wurde poliert und dann einer Murakami-Ätzung unterzogen, wobei der Schliff bei Raumtemperatur bei einer kurzen Einwirkzeit von 1-2s mit der Standard Murakami Ätzflüssigkeit bestehend aus 10 g KOH, 10 g K₃Fe(CN)₆, und 10 mml H₂O behandelt wurde. Die nachfolgende Betrachtung des so vorbereiteten Schliffbildes erfolgte mittels eines Lichtmikroskops bei 1.000 facher Vergrößerung.

Figur 3 zeigt die entsprechenden Schliffbilder. Wie sich aus den Schliffbildern ergibt, ist eine Eta-Phase an der Grenzfläche 3 zwischen dem Substrat 1 und der TiCNB Hartstoffschicht 2 bei einem Boranteil von 0 ppm im Wesentlichen nicht nachweisbar. Hieraus kann geschlossen werden, dass eine Unterkohlungsreaktion durch die Hartstoffbeschichtung im Wesentlichen nicht stattfindet, so dass sich die spröde Eta-Phase nicht ausbildet. Ein Fehlen der Unterkohlungsreaktion beziehungsweise ein Fehlen der Eta-Phase wird der Durchführung des Verfahrens als MT-CVD Verfahren mit den entsprechenden niedrigen Temperaturen zugeschrieben. Es wird daher auch bei den anderen Schliffbildern davon ausgegangen, dass die etwaige Ausbildung einer Eta-Phase nicht durch eine temperaturinduzierte Unterkohlungsreaktion an der Grenzfläche 3 stattfindet.

Auch aus den Schnittbildern in Figur 3 für die 150ppm und 380ppm lässt sich ebenfalls im Wesentlichen keine Eta-Phase erkennen.

Mit steigendem Boranteil steigt allerdings die Wahrscheinlichkeit dafür, dass sich eine spröde Wolfram-Cobalt-Bor-Phase an der Grenzfläche 3 ausbildet. Die sich so ausbildende Wolfram-Cobalt-Bor-Phase ist jedoch nicht auf eine Unterkohlungsreaktion durch die erhöhten Temperaturen innerhalb des CVD-Reaktors zurückzuführen, da in dem vorgeschlagenen Verfahren die eigentlichen Reaktionstemperaturen niedrig liegen.

Insbesondere kann das vorgeschlagene Verfahren auch als MT-CVD Verfahren bei Temperaturen von 750 °C bis 930 °C durchgeführt werden, wobei aufgrund des verwendeten organischen Precursors in Form der Alkane mit mindestens zwei C-Atomen, der Alkene oder Alkine dann immer noch die jeweiligen Kohlenstoffgehalte in der TiCNB Schicht frei eingestellt werden können.

Durch die Verwendung der Alkane, Alkene beziehungsweise Alkine kann auf diese Weise erreicht werden, dass zum einen eine harte TiCNB Schicht auf dem Substrat 1 aufgebracht wird, und andererseits kann aber die Ausbildung einer spröden Eta-Phase im Bereich der Grenzfläche 3 im Wesentlichen vermieden werden. Hieraus ergeben sich verbesserte Eigenschaften des auf diese Weise hergestellten Schneidwerkzeugs.

### Zerspanwerkzeug

Entsprechend wird ein Zerspanwerkzeug für eine Zerspanvorrichtung hergestellt, welches ein geeignetes Substrat, bevorzugt ein Hartmetallsubstrat, in der vorgegebenen Geometrie aufweist. Das Zerspanwerkzeug kann beispielsweise in Form eines Schneidkörpers für Dreh- und Fräsvorrichtungen oder in Form einer Wendeschneidplatte vorgesehen sein.

Auf dieses Substrat wird dann mit dem oben angegeben Verfahren eine TiCNB Hartstoffbeschichtung aufgebracht, wobei die TiCNB Hartstoffbeschichtung ein TiCₓN_{y}B_{1-x-y} System mit einem Kohlenstoff-zu-Stickstoff Verhältnis von 0,70 ≤ X ≤ 1,0, bevorzugt 0,75 ≤ X ≤ 0,85, aufweist.

Nach Präparation eines Schliffbildes und Murakami-Ätzung in der oben beschriebenen Form zeigt das Schliffbild im Wesentlichen keine Eta-Phase. Zur Herstellung eines Zerspanwerkzeugs wird bevorzugt auf der TiCNB Hartstoffschicht mindestens eine Deckschicht und/oder eine Funktionsschicht aufgebracht, bevorzugt eine Aluminiumoxidschicht, besonders bevorzugt eine Korundschicht und/oder eine Zirkonschicht, um die Oberflächeneigenschaften weiter an die jeweiligen Anwendungen anzupassen.

Weiterhin kann, um eine Anpassung der Oberflächenstruktur und/oder der Oberflächenrauhigkeit an die jeweilige Anwendung zu erreichen, die TiCNB Hartstoffschicht einer Nachbehandlung unterzogen werden. Diese Nachbehandlung kann beispielsweise durch Nassstrahlen, Trockenstrahlen und/oder Färben durchgeführt werden. Auch eine eventuell aufgebrachte Deckschicht und/oder Funktionsschicht kann einer solchen Nachbehandlung unterzogen werden.

## Patentansprüche

1. Verfahren zur Herstellung einer Hartstoffschicht (2) auf einem Substrat (1), wobei eine TiCNB Hartstoffschicht durch chemische Gasphasenabscheidung (CVD) aus einem Gassystem umfassend einen Titanträger, einen Borträger, einen Stickstoffträger und einen Kohlenstoffträger abgeschieden wird, **dadurch gekennzeichnet, dass** der Titanträger TiCl₄, der Borträger BCl₃ und der Stickstoffträger N₂ sind und das Gassystem H₂ als Ausgleichsgas aufweist und der Kohlenstoffträger Ethan ist und wobei der Borgehalt in dem Gassystem so eingestellt wird, dass die TiCNB Hartstoffschicht auf dem Substrat einen Borgehalt von bis zu 5 At.-%, mindestens aber 0,01 At.-% aufweist, gemessen mit dem GDOES Verfahren, wobei bei einer Reaktionstemperatur von 750 °C bis 930 °C das Kohlenstoff-zu-Stickstoff Verhältnis im auf dem Substrat abgeschiedenen TiCₓN_{y}B_{1-x-y} System bei 0,75 ≤ X ≤ 0,85 eingestellt wird.

2. Verfahren gemäß Anspruch 1, wobei das Gassystem mindestens ein weiteres Ausgleichsgas wie beispielsweise Argon aufweist.

3. Verfahren gemäß Anspruch 1 oder 2, wobei die chemische Gasphasenabscheidung bei Temperaturen von 800 ºC bis 900 ºC durchgeführt wird.

4. Verfahren gemäß einem der vorstehenden Ansprüche, wobei vor der Abscheidung der TiCNB Hartstoffschicht eine Diffusionsbarriere auf dem Substrat aufgebracht wird, bevorzugt eine Diffusionsbarriere aus Titannitrid, und die Diffusionsbarriere bevorzugt eine Schichtdicke von 0,4 µm bis 1 µm aufweist.

5. Verfahren gemäß einem der vorstehenden Ansprüche, wobei auf der TiCNB Hartstoffschicht mindestens eine Deckschicht und/oder eine Funktionsschicht aufgebracht wird, bevorzugt eine Aluminiumoxidschicht, besonders bevorzugt eine Korundschicht und/oder eine Zr(C,N)-Schicht.

6. Verfahren gemäß einem der vorstehenden Ansprüche, wobei die chemische Gasphasenabscheidung durchgeführt wird, bis eine 1 µm bis 15 µm dicke TiCNB Schicht auf dem Substrat abgeschieden ist, bevorzugt eine Schicht von 2 µm bis 12 µm Dicke, besonders bevorzugt für Fräsanwendungen eine Schicht von 3 µm bis 4 µm Dicke, und besonders bevorzugt für Drehanwendungen eine Schicht von 10 µm Dicke.

7. Hartstoffschicht (2) auf einem Substrat (1), **dadurch gekennzeichnet, dass** die Hartstoffschicht nach dem Verfahren gemäß einem der vorstehenden Ansprüche gebildet ist.

8. Zerspanwerkzeug mit einem Substrat (1) aus Hartmetall, auf welchem eine TiCNB Hartstoffschicht (2) aufgebracht ist, wobei das Verhältnis der Kohlenstoffatome (C) zu den Stickstoffatomen (N) in dem auf dem Substrat abgeschiedenen TiCₓN_{y}B_{1-x-y} System 0,75 ≤ X ≤ 0,85, ist, **dadurch gekennzeichnet, dass** das Schliffbild durch Substrat und Hartstoffschicht nach einer Murakami-Ätzung im Wesentlichen frei von einer Eta-Phase ist und wobei die TiCNB Hartstoffschicht einen Borgehalt von bis zu 5 At.-%, mindestens aber 0,01 At.-% umfasst, gemessen mit dem GDOES Verfahren.

9. Zerspanwerkzeug nach Anspruch 8, wobei zwischen dem Substrat und der TiCNB Hartstoffschicht eine Diffusionsbarriere vorgesehen ist, bevorzugt eine Diffusionsbarriere aus Titannitrid, und die Diffusionsbarriere bevorzugt eine Schichtdicke von 0,4 µm bis 1 µm aufweist.

10. Zerspanwerkzeug nach Anspruch 8 oder 9, wobei auf der TiCNB Hartstoffschicht mindestens eine Deckschicht und/oder eine Funktionsschicht aufgebracht ist, bevorzugt eine Aluminiumoxidschicht, besonders bevorzugt eine Korundschicht und/oder eine Zr(C,N)-Schicht.

11. Zerspanwerkzeug nach einem der Ansprüche 8 bis 10, wobei im Schliffbild in einer Tiefe von 0,4 µm bis 1 µm ab der Grenzfläche (3) keine Eta-Phase nachweisbar ist.

## Claims

1. A process for producing a hard material layer (2) on a substrate (1), wherein a TiCNB hard material layer is deposited by chemical vapor deposition (CVD) from a gas system comprising a titanium source, a boron source, a nitrogen source and a carbon source, **characterized in that** the titanium source is TiCl₄, the boron source is BCl₃ and the nitrogen source is N₂ and the gas system comprises H₂ as balance gas and the carbon source is ethane and wherein the boron content in the gas system is adjusted such that the TiCNB hard material layer on the substrate has a boron content of up to 5 at%, but at least 0.01 at%, measured with the GDOES method, wherein at a reaction temperature from 750°C to 930°C the carbon to nitrogen ratio in the TiCₓN_{y}B_{1-x-y} system deposited on the substrate is adjusted to 0.75 ≤ X ≤ 0.85.

2. The process as claimed in claim 1, wherein the gas system comprises at least one further balance gas such as argon for example.

3. The process as claimed in claim 1 or 2, wherein the chemical vapor deposition is carried out at temperatures from 800°C to 900°C.

4. The process as claimed in any one of the preceding claims, wherein prior to deposition of the TiCNB hard material layer a diffusion barrier is applied to the substrate, preferably a diffusion barrier of titanium nitride, and the diffusion barrier preferably has a layer thickness of from 0.4 µm to 1 µm.

5. The process as claimed in any one of the preceding claims, wherein at least one outer layer and/or one functional layer, preferably an aluminium oxide layer, more preferably a corundum layer and/or a Zr(C,N) layer, is applied to the TiCNB hard material layer.

6. The process as claimed in any one of the preceding claims, wherein the chemical vapor deposition is carried out until a 1 µm to 15 µm thick TiCNB layer is deposited on the substrate, preferably a layer of from 2 µm to 12 µm in thickness, more preferably for milling applications a layer of from 3 µm to 4 µm in thickness and more preferably for turning applications a layer of 10 µm in thickness.

7. A hard material layer (2) on a substrate (1), **characterized in that** the hard material layer is formed by the process as claimed in one of the preceding claims.

8. A cutting tool comprising a substrate (1) of cemented carbide to which a TiCNB hard material layer (2) has been applied, wherein the ratio of carbon atoms (C) to nitrogen atoms (N) in the TiCₓN_{y}B_{1-x-y} system deposited on the substrate is 0.75 ≤ X ≤ 0.85, **characterized in that** the polished section through substrate and hard material layer is essentially free of an eta phase following Murakami etching and wherein the TiCNB hard material layer has a boron content of up to 5 at%, but at least 0.01 at%, measured with the GDOES method.

9. The cutting tool as claimed in claim 8, wherein a diffusion barrier, preferably a diffusion barrier of titanium nitride, is provided between the substrate and the TiCNB hard material layer and the diffusion barrier preferably has a layer thickness of from 0.4 µm to 1 µm.

10. The cutting tool as claimed in claim 8 or 9, wherein at least one outer layer and/or a functional layer, preferably an aluminium oxide layer, more preferably a corundum layer and/or a Zr(C,N) layer, has been applied to the TiCNB hard material layer.

11. The cutting tool as claimed in any one of claims 8 to 10, wherein no eta phase is detectable in a polished section at a depth of from 0.4 µm to 1 µm from the interface (3).

## Revendications

1. Procédé de réalisation d'une couche de matériau dur (2) sur un substrat (1), dans lequel une couche de matériau dur TiCNB est déposée par dépôt chimique en phase gazeuse (CVD) depuis un système de gaz comprenant un support de titane, un support de bore, un support d'azote et un support de carbone, **caractérisé en ce que** le support de titane est du TiCl₄, le support de bore est du BCl₃ et le support d'azote est du N₂ et le système de gaz présente du H₂ comme gaz de compensation et le support de carbone est de l'éthane, la teneur en bore dans le système de gaz étant réglée de manière à ce que la couche de matériau dur TiCNB présente une teneur en bore pouvant aller jusqu'à 5 % mais soit d'au moins 0,01 %, mesurée avec le procédé GDOES, sachant que, à une température réactionnelle de 750 °C à 930 °C, le rapport entre le carbone et l'azote dans le système de TiCₓN_{y}B_{1-x-y} déposé sur le substrat est réglé à 0,75 ≤ X ≤ 0,85.

2. Procédé selon la revendication 1, dans lequel le système de gaz présente un autre gaz de compensation, comme par exemple de l'argon.

3. Procédé selon la revendication 1 ou 2, dans lequel le dépôt chimique en phase gazeuse est réalisé à des températures de 800 °C à 900 °C.

4. Procédé selon une des revendications précédentes, dans lequel, avant le dépôt de la couche de matériau dur TiCNB, une couche de diffusion est appliquée sur le substrat, de préférence une barrière de diffusion en nitrure de titane, et la barrière de diffusion présente de préférence une épaisseur de couche de 0,4 µm à 1 µm.

5. Procédé selon une des revendications précédentes, dans lequel, sur la couche de matériau dur TiCNB, est appliquée au moins une couche de couverture et/ou une couche fonctionnelle, de préférence une couche d'oxyde d'aluminium, très préférentiellement une couche de corindon et/ou une couche de Zr(C,N).

6. Procédé selon une des revendications précédentes, dans lequel le dépôt chimique en phase gazeuse est réalisé jusqu'à ce que soit déposée sur le substrat une couche de TiCNB d'une épaisseur de 1 µm à 15 µm, de préférence une couche d'une épaisseur de 2 µm à 12 µm, très préférentiellement pour les applications de fraisage une couche d'une épaisseur de 3 µm à 4 µm, et particulièrement préférentiellement pour les applications de tournage une couche d'une épaisseur de 10 µm.

7. Couche de matériau dur (2) sur un substrat (1), **caractérisée en ce que** la couche de matériau dur est constituée d'après le procédé selon une des revendications précédentes.

8. Outil d'enlèvement de copeaux comportant un substrat (1) en carbure, sur lequel est appliquée une couche de matériau dur TiCNB (2), le rapport entre les atomes de carbone (C) et les atomes d'azote (N) étant, dans le système TiCₓN_{y}B_{1-x-y} déposé sur le substrat, de 0,75 ≤ X ≤ 0,85, **caractérisé en ce que** le ponçage, grâce au substrat et à la couche de matériau dur, après une gravure Murakami, est sensiblement exempt d'une phase Eta, la couche de matériau dur TiCNB comportant une teneur en bore pouvant aller jusqu'à 5 % mais qui est d'au moins 0,01 %, mesurée avec le procédé GDOES.

9. Outil d'enlèvement de copeaux selon la revendication 8, dans lequel, entre le substrat et la couche de matériau dur TiCNB, une barrière de diffusion est prévue, de préférence une barrière de diffusion en nitrure de titane, et la barrière de diffusion présente de préférence une épaisseur de couche de 0,4 µm à 1 µm.

10. Outil d'enlèvement de copeaux selon la revendication 8 ou 9, dans lequel, sur la couche de matériau dur TiCNB, est appliquée au moins une couche de couverture et/ou une couche fonctionnelle, de préférence une couche d'oxyde d'aluminium, très préférentiellement une couche de corindon et/ou une couche de Zr(C,N).

11. Outil d'enlèvement de copeaux selon une des revendications 8 à 10, dans lequel, dans le ponçage, à une profondeur de 0,4 µm à 1 µm à partir de la surface limite (3), aucune phase Et a n'est décelable.
